(19) **Europäisches Patentamt / European Patent Office / Office européen des brevets**

(11) **EP 2 798 672 B1**

(12) **FASCICULE DE BREVET EUROPEEN**

(45) Date de publication et mention
de la délivrance du brevet:
**23.12.2015 Bulletin 2015/52**

(21) Numéro de dépôt: **12819116.0**

(22) Date de dépôt: **27.12.2012**

(51) Int Cl.:
**H01L 21/762** *(2006.01)*

(86) Numéro de dépôt international:
**PCT/FR2012/053090**

(87) Numéro de publication internationale:
**WO 2013/098529 (04.07.2013 Gazette 2013/27)**

(54) **PROCEDE DE FABRICATION D'UNE STRUCTURE MULTICOUCHE SUR UN SUPPORT**

VERFAHREN ZUR HERSTELLUNG EINER MEHRSCHICHTIGEN STRUKTUR AUF EINEM SUBSTRAT

METHOD FOR MANUFACTURING A MULTILAYER STRUCTURE ON A SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.12.2011 FR 1162524**

(43) Date de publication de la demande:
**05.11.2014 Bulletin 2014/45**

(73) Titulaire: **Commissariat à l'Énergie Atomique et aux Énergies Alternatives
75015 Paris (FR)**

(72) Inventeurs:
• **ROSSINI, Umberto
F-38500 Coublevie (FR)**

• **ELEOUET, Raphael
F-38430 Moirans (FR)**
• **FLAHAUT, Thierry
F-38220 Cholonge (FR)**

(74) Mandataire: **Thibon, Laurent
Cabinet Beaumont
1, rue Champollion
38000 Grenoble (FR)**

(56) Documents cités:
**FR-A1- 2 789 518       FR-A1- 2 848 337
US-A1- 2009 102 008**

**Description**

Domaine de l'invention

La présente invention concerne un procédé de fabrication d'une structure multicouche, correspondant par exemple à une plaquette de circuits intégrés, sur un support par collage moléculaire.

Exposé de l'art antérieur

Le document FR 2 848 337 décrit un procédé de réalisation d'une structure microélectronique complexe qui consiste à assembler deux structures microélectroniques élémentaires par deux faces respectives de liaison. Avant l'assemblage, on crée une différence d'état de contraintes tangentielles entre les deux faces à assemble. Cette différence est choisie en sorte d'obtenir au sein de la structure assemblée un état de contraintes prédéterminé dans des conditions données par rapport aux conditions d'assemblage. Pour certaines applications, il est souhaitable de réaliser une plaquette de circuits intégrés sur un support. En particulier, pour des applications dans le domaine de l'optique, le support doit être isolant et transparent. Il s'agit par exemple de verre. Un exemple d'application concerne la fabrication d'un écran de visualisation transmissif.

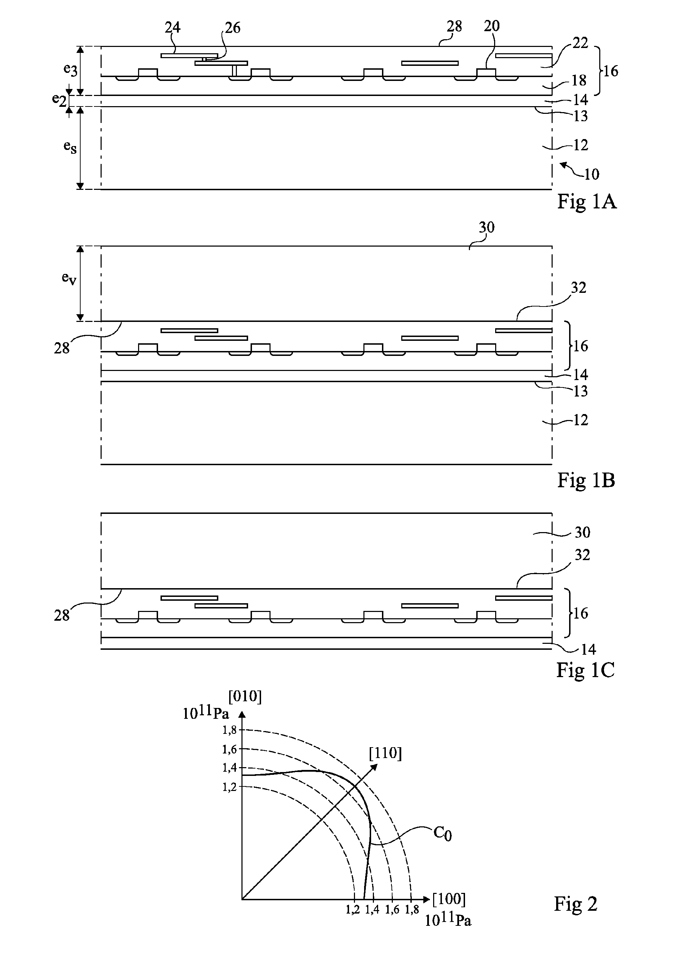

Les figures 1A à 1C représentent des coupes schématiques de structures obtenues à des étapes successives d'un procédé de fabrication d'une plaquette de circuits intégrés sur un support par collage moléculaire.

La figure 1A représente, de façon schématique, un élément 10 ayant une structure du type SOI (acronyme anglais pour Silicon On Insulator).

L'élément 10 comprend un support initial 12, par exemple un substrat de silicium monocristallin. L'épaisseur $e_S$ du support initial 12 est, par exemple, de plusieurs centaines de micromètres, et est, par exemple, égale à environ 700 $\mu$m. Le support initial 12 peut correspondre à un cylindre dont le diamètre est supérieur à une centaine de millimètres, et est égal, par exemple, à environ 200 mm ou 300 mm. Le support initial 12 comprend une face plane 13 recouverte d'une couche isolante 14, par exemple en dioxyde de silicium. L'épaisseur $e_2$ de la couche isolante 14 est, par exemple, de l'ordre de 1 $\mu$m. La couche isolante 14 est recouverte d'une plaquette de circuits intégrés 16. La plaquette de circuits intégrés 16 comprend un empilement de couches dans lequel sont formés des composants électroniques actifs et/ou passifs et des pistes conductrices reliant ces composants. A titre d'exemple, la plaquette de circuits intégrés 16 comprend une couche 18 d'un matériau semiconducteur, par exemple du silicium monocristallin, recouvrant la couche isolante 14 et dans et sur laquelle sont formés les composants électroniques actifs et/ou passifs, par exemple des transistors 20. La plaquette de circuits intégrés 16 comprend, en outre, un empilement de couches isolantes 22, par exemple en dioxyde de silicium, recouvrant la couche de silicium 18 et dans lequel sont formés des pistes 24 et des vias 26 d'un matériau conducteur pouvant venir au contact des composants électroniques. A titre d'exemple, l'épaisseur $e_3$ de la plaquette 16 est de l'ordre de quelques micromètres. La dernière couche isolante de l'empilement 22 de couches isolantes forme une face supérieure plane 28 opposée au support 12.

La figure 1B représente la structure obtenue après la réalisation d'un collage moléculaire entre la face 28 de l'élément 10 et un support final 30. Le support final 30 est en un matériau différent du silicium, par exemple en verre. L'épaisseur $e_V$ du support final 30 est supérieure à plusieurs centaines de micromètres, et est, par exemple, égale à environ 700 $\mu$m. Le support final 30 comprend une face 32 appliquée contre la face 28. Le collage moléculaire consiste à créer une liaison entre les faces 28 et 32 sans l'apport de matière extérieure (comme une colle ou une matière adhésive). Pour cela, les faces 28 et 32, convenablement nettoyées, sont mises au contact l'une de l'autre à température ambiante. Une pression peut être exercée localement sur le support 30 pour amorcer le collage. Le front de propagation de la zone collée se répand alors de la région d'amorce sur l'ensemble des surfaces en regard.

La figure 1C représente la structure obtenue après le retrait du support initial 12. Le retrait du support initial 12 peut comprendre une étape de rectification mécano-chimique pour retirer la plus grande partie du support initial 12 suivie d'une étape de gravure chimique sélective pour retirer le reste du support initial 12. La couche isolante 14 peut servir de couche d'arrêt lors du retrait du support initial 12.

Le procédé se poursuit généralement par la réalisation de vias conducteurs au travers de la couche isolante 14 et de la couche de silicium 18 et connectés à des pistes métalliques 24 de la plaquette de circuits intégrés 16. La formation de ces vias comprend des étapes de photolithographie, incluant des étapes dans lesquelles une couche d'une résine photosensible recouvrant la couche isolante 14 est exposée à un rayonnement au travers d'un masque pour reproduire le motif du masque sur la couche de résine. Dans ce but, le dispositif d'exposition, qui comprend notamment les systèmes optiques pour former le motif dans la couche de résine photosensible, doit être placé avec précision par rapport à la plaquette de circuits intégrés 16.

Dans un procédé de fabrication à une échelle industrielle, les étapes de photolithographie doivent être réalisées le plus rapidement possible. Dans ce but, le dispositif d'exposition est réglé au préalable pour que le motif à transférer se forme sans réglage supplémentaire de façon correcte dans la couche de résine pour une plaquette de circuits intégrés qui aurait les dimensions attendues.

Toutefois, des déformations sont observées dans la plaquette de circuits intégrés 16 après l'étape de collage. En particulier, un rétrécissement est observé, c'est-à-dire que deux repères formés sur la face de collage 28 avant l'étape de collage sont rapprochés l'un de l'autre après l'étape de collage.

En outre, les déformations relatives observées dans la plaquette de circuits intégrés 16 dans un plan parallèle à la face 28 varient généralement selon la direction considérée. De ce fait, le rétrécissement relatif observé peut varier entre environ 16 ppm et 24 ppm selon la direction considérée, parallèlement à la face 28.

Une déformation moyenne de 20 ppm peut généralement être compensée par le dispositif d'exposition. Néanmoins, dans certains cas, la déformation moyenne peut être trop importante pour être compensée par le dispositif d'exposition. En outre, il n'est pas possible de corriger, par le dispositif d'exposition, les différences de déformations relatives qui varient selon la direction considérée. De ce fait, il peut y avoir des erreurs d'alignement entre le dispositif d'exposition et la plaquette de circuits intégrés lors des étapes de photolithographie réalisées après le collage.

Un besoin existe donc d'un procédé de fabrication par collage moléculaire d'une structure multicouche, correspondant par exemple à une plaquette de circuits intégrés, sur un support dans lequel les déformations dans la plaquette de circuits intégrés qui résultent de l'opération de collage sont réduites, voire supprimées.

Résumé

Un objet de la présente invention est de proposer un procédé de fabrication d'une structure multicouche sur un support par collage moléculaire qui pallie les inconvénients des procédés connus.

Selon un autre objet de la présente invention, les déformations relatives dans la structure multicouche qui résultent de l'opération de collage sont inférieures à 5 ppm.

Selon un autre objet de la présente invention, le procédé de fabrication par collage moléculaire comporte un nombre réduit d'étapes supplémentaires par rapport à un procédé de fabrication par collage moléculaire connu.

Ainsi, la présente invention prévoit un procédé de fabrication d'une structure multicouche sur un premier support en un premier matériau ayant un premier module d'Young. Le procédé comprend les étapes successives suivante :

prévoir un second support recouvert de la structure multicouche, la structure multicouche ayant une face plane opposée au second support, le second support étant en un second matériau ayant un second module d'Young différent du premier module d'Young ;

appliquer à ladite face des premières déformations ;

réaliser un collage moléculaire du premier support sur ladite face, le collage moléculaire entraînant l'apparition de secondes déformations dans ladite face en l'absence des premières déformations, les premières déformations étant opposées aux secondes déformations ; et

retirer le second support, les déformations relatives résultantes dans ladite face étant inférieures à 5 ppm.

Le fait que les premières déformations sont opposées aux secondes déformations signifie que les premières déformations sont sensiblement égales en valeur absolue aux secondes déformations et sont de sens opposé.

Selon un exemple de réalisation de l'invention, ladite face est déformée en appliquant le second support sur un gabarit.

Selon un exemple de réalisation de l'invention, ladite face est déformée en maintenant fixe le centre du second support et en déplaçant la périphérie du second support.

Selon un exemple de réalisation de l'invention, les premières déformations varient en fonction des directions cristallographiques du second support.

Selon un exemple de réalisation de l'invention, l'application des premières déformations comprend la mise en extension de ladite face.

Selon un exemple de réalisation de l'invention, le second support est en silicium monocristallin, ladite face étant une face cristallographique (001), le second support étant un cylindre ayant un axe de symétrie de révolution, et les premières déformations ayant une symétrie de révolution d'ordre 4 autour dudit axe.

Selon un exemple de réalisation de l'invention, l'application des premières déformations comprend l'application, dans un premier plan contenant ledit axe et la direction cristallographique [100] ou [010] du second support, d'un premier écartement, mesuré selon ledit axe, entre le centre et la périphérie de ladite face, et dans un second plan contenant ledit axe et la direction cristallographique [110] du second support, d'un second écartement, mesuré selon ledit axe, entre le centre et la périphérie de ladite face, le premier écartement étant strictement inférieur au second écartement.

Selon un exemple de réalisation de l'invention, le premier matériau est isolant.

Selon un exemple de réalisation de l'invention, le premier matériau est transparent.

Selon un exemple de réalisation de l'invention, le premier matériau est du verre.

Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :

les figures 1A à 1C, décrites précédemment, représentent les structures obtenues à des étapes successives d'un procédé de fabrication connu d'une plaquette de circuits intégrés sur un support isolant ;
la figure 2 représente l'évolution du module d'Young dans un plan (100) d'un support en silicium monocristallin ;
la figure 3 est une coupe schématique illustrant le principe de l'invention ;
la figure 4 est une coupe schématique d'un exemple de réalisation d'un système de déformation d'un support selon l'invention ;
la figure 5 représente une vue en perspective avec coupe du gabarit du système de déformation de la figure 4 ;
les figures 6 et 7 sont respectivement une coupe latérale schématique et une vue de dessous, partielles et schématiques, d'un autre exemple de réalisation d'un système de déformation d'un support selon l'invention ; et
les figures 8A à 8E représentent des structures obtenues à des étapes successives d'un exemple de réalisation d'un procédé de fabrication connu d'une plaquette de circuits intégrés sur un support isolant selon l'invention.

Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Le principe de l'invention se base sur une analyse des phénomènes physiques qui se produisent lors d'une opération de collage moléculaire de deux supports comprenant des matériaux de natures différentes. Au niveau du front de propagation de la zone collée, on observe une mise en extension locale des supports. Lorsque les modules d'Young des matériaux des supports sont différents, les déformations locales résultantes ne sont pas identiques. La face collée du support dont le module d'Young est le plus faible s'étend davantage que la face collée du support dont le module d'Young est le plus élevé. Le collage se produit alors que les supports sont déformés. Après avoir collé les deux supports et retiré l'un des supports pour ne laisser qu'une couche mince collée à l'autre support, des déformations dans la couche mince sont observées.

En général, lors du collage d'une plaquette de circuits intégrés sur un support final en verre, la plaquette de circuits intégrés repose sur un support initial, retiré par la suite, qui est un substrat de silicium monocristallin. Les inventeurs ont mis en évidence que, lors du collage moléculaire de la plaquette de circuits intégrés sur le support final, les déformations résultantes observées dans la plaquette de circuits intégrés sont essentiellement dues à la nature du matériau du support initial utilisé pour l'application de la plaquette de circuits intégrés contre le support final. En effet, l'épaisseur de la plaquette de circuits intégrés est faible par rapport à l'épaisseur du support initial et il est possible de la négliger. Le module d'Young du verre est inférieur au module d'Young du silicium de sorte que l'on observe, après le collage, un agrandissement relatif négatif dans un plan de la plaquette de circuits intégrés parallèle aux faces collées qui dépend de la direction considérée.

Les inventeurs ont mis en évidence que les différences de déformations relatives dans la plaquette de circuits intégrés provenaient des propriétés mécaniques anisotropes du matériau formant le support initial. En particulier, les inventeurs ont mis en évidence que les différences de déformations relatives dans la plaquette de circuits intégrés étaient liées aux variations du module d'Young du matériau formant le support initial selon la direction considérée dans un plan parallèle aux faces collées.

La figure 2 représente une courbe $C_0$ d'évolution du module d'Young dans un plan cristallographique (100) du support 12 en silicium monocristallin. Le module d'Young varie entre une valeur d'environ 130 GPa pour les directions cristallographiques [100] et [010] et une valeur de 170 GPa pour la direction cristallographique [110].

Pour les structures SOI actuellement disponibles dans le commerce, la face 13 du support initial 12 en silicium correspond généralement à une face cristallographique (100). Les inventeurs ont observé que le rétrécissement relatif est de l'ordre de 16 ppm dans les directions cristallographiques [100] et [010] et est de l'ordre de 24 ppm dans la direction cristallographique [110].

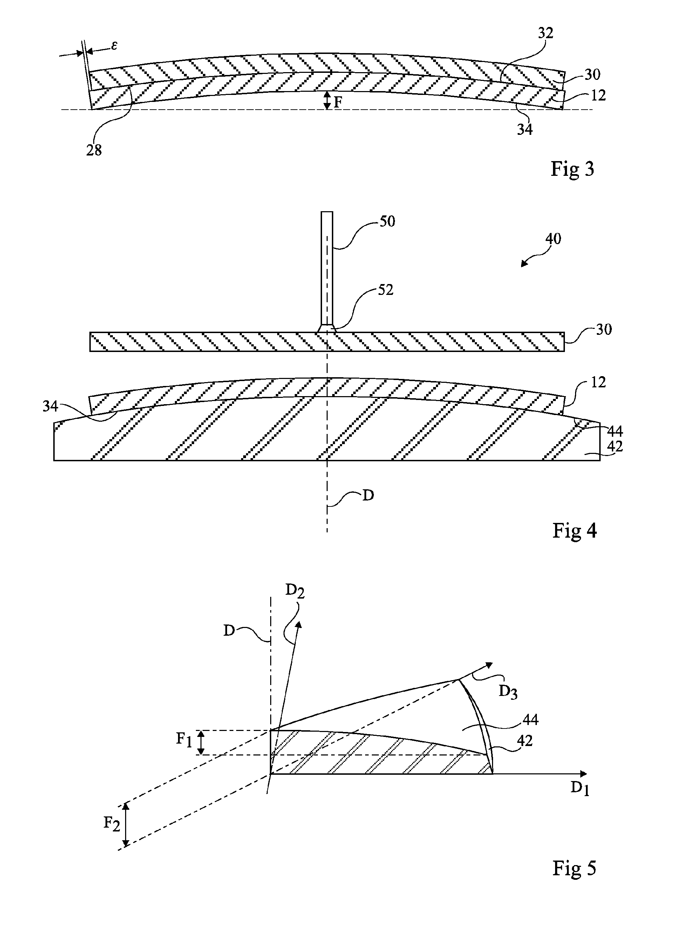

La figure 3 illustre le principe du présent exemple de réalisation de l'invention. Les inventeurs ont mis en évidence qu'il est possible de compenser les déformations qui résultent du collage moléculaire de deux supports de matériaux ayant des modules d'Young différents en appliquant une déformation déterminée à l'un des supports avant et pendant le collage.

Plus précisément, en figure 3, on a représenté de façon schématique le support initial 12 et le support final 30. Les inventeurs ont mis en évidence que la couche isolante 14 et la plaquette 16, dont les épaisseurs sont nettement inférieures aux épaisseurs des supports 12, 30, peuvent être négligées et il peut être considéré que la face 28 est la face du support 12. Le support 12 est en silicium monocristallin et le support 30 est en verre de sorte qu'un collage moléculaire entre les supports 12, 30 entraîne l'apparition d'un rétrécissement de la face 28 du support 12. Le principe de l'invention est de déformer le support en silicium 12 avant le collage et de coller le support 30 au support 12 alors que le support 12 est déformé. Plus précisément, le support en silicium 12 est déformé en maintenant fixe le centre du support 12 et en déplaçant certains points de la périphérie du support 12 d'une distance F. La face 28 du support 12 est alors mise en traction alors que la face 34 du support 12 opposée à la face 28 est mise en compression. Si on considère que le support 30 est seulement posé sans collage sur la face 28 du support 12, il épouse la forme du support 12 de sorte que la face 32 du support 30 est mise en compression. Lorsque les deux supports 12 et 30 correspondent à des cylindres de même rayon r, un écart $\varepsilon$ apparaît entre le bord périphérique du support 30 et le bord périphérique du support 12. L'écart $\varepsilon$ dépend de la distance F. La valeur de la distance F est choisie pour que l'écart $\varepsilon$ soit égal, en valeur absolue, au rétrécissement relatif entre le support 12 et le support 30 après collage en l'absence de déformation préalable du support 12. Les inventeurs ont mis en évidence que, après le collage et le relâchement du support 12, le rétrécissement du support 12 est alors sensiblement nul.

De façon générale, la distance F est obtenue par la relation (1) suivante :

$$F \;=\; \frac{1}{2}\,\frac{r^2}{e_s}\,\varepsilon \tag{1}$$

La distance F, à appliquer pour compenser les déformations dues au collage, peut être obtenue par la relation (2) suivante :

$$F \;=\; \sqrt{\frac{3}{4}\,\xi_{coll}\,\frac{r^4}{e_s{}^3}\,\frac{(E_s \,-\, E_v)^2}{E_s E_v (E_s \,+\, E_v)}} \tag{2}$$

où $E_V$ est le module d'Young du support final, $E_S$ est le module d'Young du support initial et $\xi_{coll}$ est une portion de l'énergie de collage.

A titre de variante, le support en silicium 12 peut être déformé en maintenant fixe un point ou plusieurs points de la périphérie du support 12 et en déformant le reste de la périphérie du support en silicium 12.

La figure 4 représente un exemple de réalisation d'un système 40 adapté à la réalisation d'un collage moléculaire entre les supports 12 et 30 tout en maintenant le support 12 sous une forme déformée.

Le système 40 comprend un gabarit 42. Le gabarit 42 comprend une face d'appui 44 contre laquelle est appliqué le support 12. La face 44 est une surface courbe dont la forme est adaptée pour obtenir la déformation souhaitée du support 12. Le gabarit 42 comprend, en outre, un système d'aspiration, non représenté. Le système d'aspiration est adapté à maintenir la face 34 du support 12 en appui contre la face 44. Le gabarit 42 est, par exemple, réalisé en un matériau céramique. Le gabarit 42 peut, en outre, comprendre un revêtement, par exemple en téflon, sur la face 44 pour faciliter le glissement latéral du support 12 lors du collage moléculaire.

Le système 40 comprend, en outre, un bras 50 mobile en translation selon un axe D, par exemple vertical. Le bras 50 comprend à une extrémité un élément de préhension 52, par exemple une ventouse ou un élément d'aspiration. Le support 30 est maintenu par l'élément de préhension 52 du bras 50. De préférence, lorsque les supports 12, 30 sont cylindriques, l'axe D correspond à l'axe des supports 12, 30.

Pour réaliser le collage moléculaire du support 30 sur le support 12, le bras mobile 50 est rapproché du gabarit 42 jusqu'à ce que le support 30 vienne au contact du support 12 au niveau de l'axe D. Les forces présentes lors du collage sont suffisantes pour déformer le support 30 qui épouse alors la forme du support 12.

La figure 5 est une vue en perspective d'un secteur d'un exemple de réalisation du gabarit 42 adapté au cas où le support 12 est en silicium et la face 28 est une face cristallographique (100). Le secteur correspond à $1/8^{\text{ème}}$ du gabarit 42. La face 44 a une symétrie de révolution autour de l'axe D d'ordre 4. On appelle $D_1$, $D_2$ et $D_3$ respectivement les directions cristallographiques [100], [010] et [110] de la face 28 du support 12. Dans les plans contenant l'axe D et les directions $D_1$ et $D_2$, la face 44 correspond à la déformée obtenue pour un écartement $F_1$ et dans le plan contenant l'axe D et la direction $D_3$, la face 44 correspond à la déformée obtenue pour un écartement $F_2$. L'écartement $F_2$ est supérieur à l'écartement $F_1$. Les valeurs d'écartement $F_1$ et $F_2$ peuvent être déterminées à partir de la relation (2) et des valeurs suivantes :

module d'Young $E_V$ égal à 70 GPa ;
module d'Young $E_S$ égal à 130 GPa dans la direction cristallographique [100] ou [010] et égal à 170 GPa dans la direction cristallographique [110] ;
portion d'énergie de collage $\xi_{coll}$ égale à 30 mJ/m$^2$ ;
rayon r égal à 100 mm ; et
épaisseur $e_S$ égale à 700 $\mu$m.

A titre d'exemple, l'écartement $F_1$ est de l'ordre de 122 micromètres et l'écartement $F_2$ est de l'ordre de 163 micromètres.

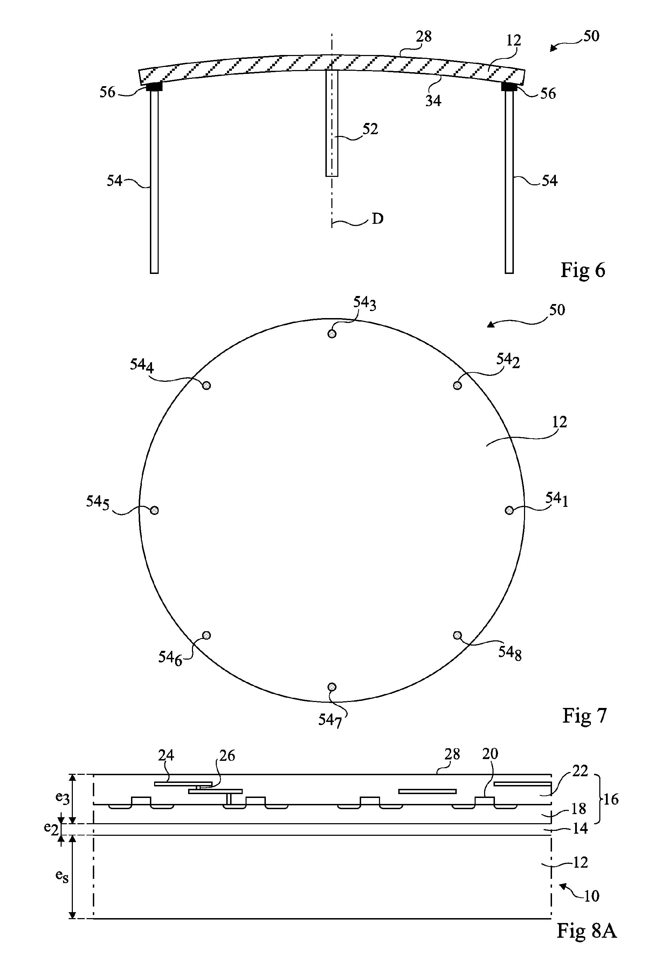

Les figures 6 et 7 représentent, de façon partielle et schématique, un autre exemple de réalisation d'un système 50 adapté à la réalisation d'un collage moléculaire entre les supports 12 et 30 tout en maintenant le support 12 sous une forme déformée.

Le système 50 comprend un doigt central 52, correspondant par exemple à un cylindre d'axe D, sur lequel repose le support 12. Le système 50 comprend, en outre, des bras mobiles 54 disposés à la périphérie du support 12. Chaque bras mobile 54 comprend, à une extrémité, un élément de préhension 56, par exemple une ventouse ou un dispositif d'aspiration. La face 34 du support 12 peut, de façon temporaire, être fixée aux bras 54. Les bras 54 peuvent se déplacer selon des axes parallèles à l'axe D. En fonctionnement, les bras mobiles 54 sont adaptés à exercer une traction sur le support 12 à la périphérie de la face 34. Puisque le support 12 est maintenu par le doigt central 52, un déplacement des bras 54 entraîne une déformation du support 12 qui adopte une forme générale bombée. Les bras 54 peuvent être déplacés pour que la face 34 reproduise la forme de la face 44 du gabarit 42 représentée en figure 5. A titre d'exemple, comme cela est représenté en figure 7, le système 50 comprend huit bras mobiles $54_1$ à $54_8$ répartis régulièrement à la périphérie du support 12. A titre d'exemple, le support 12 est orienté par rapport aux bras $54_1$ à $54_8$ de sorte que le plan contenant les axes des bras $54_1$ et $54_5$ contienne également la direction cristallographique [100] ou [010]. Dans ce cas, le plan contenant les axes des bras $54_3$ et $54_7$ contient également la direction cristallographique [100] ou [010] et le plan contenant les axes des bras $54_2$ et $54_6$ ou le plan contenant les axes des bras $54_4$ et $54_8$ contient également la direction cristallographique [110].

Le système 50 comprend, en outre, comme pour le système 40, un bras supplémentaire, non représenté, qui est adapté à appliquer le support 30 contre le support 12, lorsque le support 12 est déformé.

Les figures 8A à 8E représentent les structures obtenues à des étapes successives d'un exemple de réalisation d'un procédé de fabrication d'une plaquette de circuits intégrés sur un support isolant selon l'invention.

La figure 8A représente une structure identique à la structure représentée en figure 1A. L'épaisseur $e_S$ du support initial 12 est par exemple de l'ordre de 700 micromètres. Ceci correspond à l'épaisseur standard des substrats de silicium utilisés de façon classique dans les procédés de fabrication de circuits intégrés.

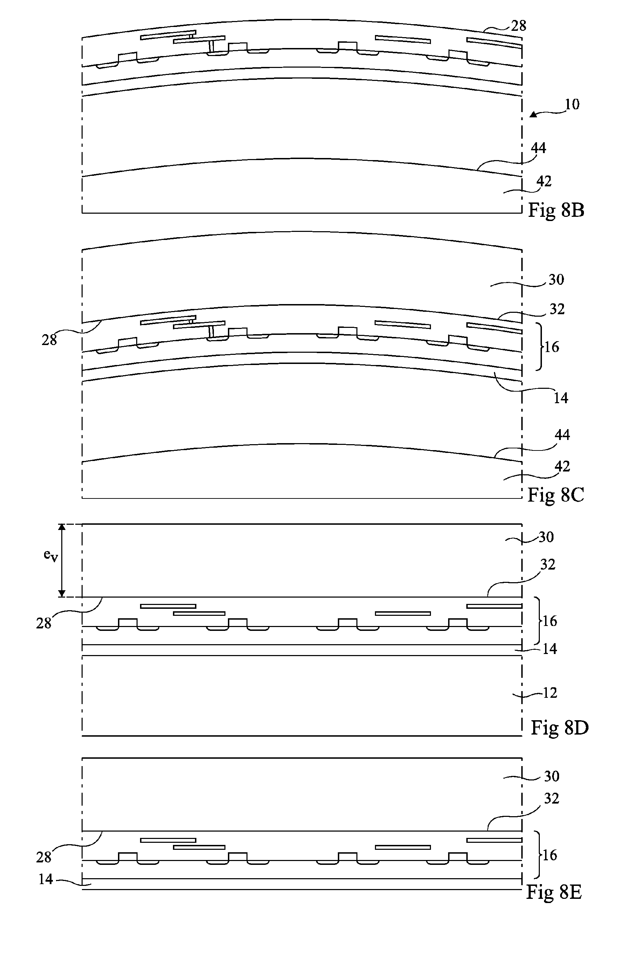

La figure 8B représente une structure obtenue après avoir déformé l'élément 10, par exemple en l'appliquant contre la face 44 du gabarit 42 du système de déformation illustré aux figures 4 et 5. La face 28 a alors la même forme que la face 44 telle qu'illustrée en figure 5. A titre de variante, l'élément 10 peut être déformé en utilisant le système 50 représenté aux figures 6 et 7.

La figure 8C représente la structure obtenue après la réalisation d'un collage moléculaire entre la couche isolante supérieure de l'empilement 16 et le support final 30. Le support final 30 est en un matériau isolant et transparent. Il s'agit par exemple de verre. Il s'agit par exemple du verre à base de borosilicate commercialisé par la société Corning sous l'appellation Eagle 2000.

De façon connue, le procédé de collage moléculaire peut comprendre des étapes de préparation des faces 28 et 32 à coller. Si besoin, un traitement peut être réalisé pour que la rugosité des faces 28 et 32 soit adaptée à la réalisation d'un collage moléculaire. Les étapes de préparation peuvent, en outre, comprendre le nettoyage des faces 28 et 32 visant à retirer la majorité des particules présentes sur les faces 28 et 32 dont le diamètre est, par exemple, supérieur à 0,2 $\mu$m. Les étapes de préparation peuvent, en outre, comprendre un traitement chimique des faces 28 et 32 pour favoriser un collage moléculaire de type hydrophile ou hydrophobe.

Le collage peut être réalisé à température ambiante. Le collage peut être amorcé en plaquant les faces 28 et 32 l'une contre l'autre et en appliquant une pression localisée sur l'un des supports. Le collage débute alors dans une zone d'amorce et un front de propagation de collage se répand depuis la zone d'amorce jusqu'à ce que la face 28 soit collée en totalité à la face 32. Lorsque les supports 30 et 12 sont cylindriques, la zone d'amorce peut être prévue en région centrale des faces 28 et 32. A titre de variante, la zone d'amorce peut être située sur un bord des faces 28 et 32. Une étape de recuit peut ensuite être réalisée à une température inférieure à la température maximale autorisée pour les matériaux utilisés. Lorsque le support final 30 est en verre, le recuit peut être réalisé jusqu'à une température de 400°C à 500°C pendant une durée d'au moins 1 heure, et en général de plusieurs heures, pour augmenter l'énergie de collage.

La figure 8D représente la structure obtenue après avoir arrêté la déformation du support 12. Les faces collées 28 et 32 redeviennent sensiblement planes.

La figure 8E représente la structure obtenue après le retrait du support initial 12. Le retrait du support initial 12 peut comprendre une étape de rectification mécano-chimique pour retirer la plus grande partie du support initial 12 suivie d'une étape de gravure chimique sélective pour retirer le reste du support initial 12. La couche isolante 14 peut servir de couche d'arrêt lors du retrait du support initial 12.

Le procédé se poursuit généralement par la formation de vias conducteurs au travers de la couche isolante 14 et de la couche de silicium 12.

Des exemples de réalisation particuliers de la présente invention ont été décrits. Diverses variantes et modifications apparaîtront à l'homme de l'art. En particulier, bien que dans l'exemple de réalisation décrit précédemment, le support final soit en verre et le support initial soit en silicium, il est clair que la présente invention peut s'appliquer au collage moléculaire de tout type de matériau ayant des modules d'Young différents. A titre d'exemple, le support initial et/ou le support final peuvent être en un matériau semiconducteur, par exemple du silicium, du germanium ou de l'arséniure de gallium, en un matériau isolant, par exemple du quartz ou du saphir, ou en tout matériau à bas coût pouvant être utilisé pour réaliser un substrat poignée, par exemple un polymère.

**Revendications**

1. Procédé de fabrication d'une structure multicouche (16) sur un premier support (30) en un premier matériau ayant un premier module d'Young, le procédé comprenant les étapes successives suivantes :

   prévoir un second support (12) recouvert de la structure multicouche, la structure multicouche ayant une face (28) plane opposée au second support, le second support étant en un second matériau ayant un second module d'Young différent du premier module d'Young ;
   appliquer à ladite face des premières déformations qui varient en fonction des directions cristallographiques du second support (12) ;
   réaliser un collage moléculaire du premier support sur ladite face, le collage moléculaire entraînant l'apparition de secondes déformations dans ladite face en l'absence des premières déformations, les premières déformations étant opposées aux secondes déformations ; et
   retirer le second support, les déformations relatives résultantes dans ladite face étant inférieures à 5 ppm.

2. Procédé de fabrication selon la revendication 1, dans lequel ladite face (28) est déformée en appliquant le second support (12) sur un gabarit (42).

3. Procédé de fabrication selon la revendication 1, dans lequel ladite face (28) est déformée en maintenant fixe le centre du second support (12) et en déplaçant la périphérie du second support.

4. Procédé de fabrication selon l'une quelconque des revendications 1 à 3, dans lequel l'application des premières déformations comprend la mise en extension de ladite face (28).

5. Procédé de fabrication selon la revendication 4, dans lequel le second support (12) est en silicium monocristallin, dans lequel ladite face (28) est une face cristallographique (001), dans lequel le second support (12) est un cylindre ayant un axe (D) de symétrie de révolution, et dans lequel les premières déformations ont une symétrie de révolution d'ordre 4 autour dudit axe.

6. Procédé de fabrication selon la revendication 5, dans lequel l'application des premières déformations comprend l'application, dans un premier plan contenant ledit axe (D) et la direction cristallographique [100] ou [010] du second support (12), d'un premier écartement, mesuré selon ledit axe, entre le centre et la périphérie de ladite face (28), et dans un second plan contenant ledit axe et la direction cristallographique [110] du second support, d'un second écartement, mesuré selon ledit axe, entre le centre et la périphérie de ladite face, le premier écartement étant strictement inférieur au second écartement.

7. Procédé de fabrication selon l'une quelconque des revendications 1 à 6, dans lequel le premier matériau est isolant.

8. Procédé de fabrication selon l'une quelconque des revendications 1 à 7, dans lequel le premier matériau est transparent.

9. Procédé de fabrication selon l'une quelconque des revendications 1 à 8, dans lequel le premier matériau est du verre.

**Patentansprüche**

1. Verfahren zur Herstellung einer mehrlagigen Struktur (16) auf einem ersten Träger (30), der aus einem ersten Material mit einem ersten Elastizitätsmodul gemacht ist, wobei das Verfahren die aufeinanderfolgenden Schritte aufweist:

Vorsehen eines zweiten Trägers (12), der mit einer mehrlagigen Struktur bedeckt ist, wobei die mehrlagige Struktur eine ebene Oberfläche (28) gegenüberliegend zum zweiten Träger hat, wobei der zweite Träger aus einem zweiten Material mit einem zweiten Elastizitätsmodul gemacht ist, der von dem ersten Elastizitätsmodul abweicht;
Aufbringen von ersten Verformungen an der Oberfläche, die gemäß den Kristallrichtungen des zweiten Trägers (12) variieren;
Ausführen einer Molekularverbindung des ersten Trägers auf der Oberfläche, wobei die Molekularverbindung das Auftreten von zweiten Verformungen in der Oberfläche in Abwesenheit der ersten Verformungen bewirkt, wobei die ersten Verformungen entgegengesetzt zu den zweiten Verformungen sind; und
Entfernen des zweiten Trägers, wobei die daraus resultierenden relativen Verformungen in der Oberfläche kleiner als 5 ppm sind.

2. Herstellungsverfahren nach Anspruch 1, wobei die Oberfläche (28) durch Aufbringen des zweiten Trägers (12) auf einer Probe (42) verformt wird.

3. Herstellungsverfahren nach Anspruch 1, wobei die Oberfläche (28) verformt wird, indem die Mitte des zweiten Trägers (12) fixiert gehalten wird und indem der Umfang des zweiten Trägers verschoben wird.

4. Herstellungsverfahren nach einem der Ansprüche 1 bis 3, wobei das Aufbringen der ersten Verformungen aufweist, die Oberfläche (28) zu strecken.

5. Herstellungsverfahren nach Anspruch 4, wobei der zweite Träger (12) aus einkristallinem Silizium gemacht ist, wobei die Oberfläche (28) eine (001) Kristalloberfläche ist, wobei der zweite Träger (12) ein Zylinder mit einer Drehsymmetrieachse (D) ist, und wobei die ersten Verformungen eine Drehsymmetrie vierter Grades um die Achse haben.

6. Herstellungsverfahren nach Anspruch 5, wobei das Aufbringen der ersten Verformungen aufweist, in einer ersten Ebene, welche die Achse (D) und die Kristallrichtung [100[ oder [010] des zweiten Trägers (12) enthält, eine erste Beabstandung gemessen entlang der Achse zwischen der Mitte und dem Umfang der Oberfläche (28) aufzubringen und in einer zweiten Ebene, welche die Achse und die Kristallrichtung (110) des zweiten Trägers enthält, eine zweite Beabstandung gemessen entlang der Achse zwischen der Mitte und dem Umfang der Oberfläche aufzubringen, wobei die erste Beabstandung kleiner ist als die zweite Beabstandung.

7. Herstellungsverfahren nach einem der Ansprüche 1 bis 6, wobei das erste Material isolierend ist.

8. Herstellungsverfahren nach einem der Ansprüche 1 bis 7, wobei das erste Material transparent ist.

9. Herstellungsverfahren nach einem der Ansprüche 1 bis 8, wobei das erste Material Glas ist.

**Claims**

1. A method of manufacturing a multilayer structure (16) on a first support (30) made of a first material having a first Young's modulus, the method comprising the successive steps of:

providing a second support (12) covered with the multilayer structure, the multilayer structure having a planar surface (28) opposite to the second support, the second support being made of a second material having a second Young's modulus different from the first Young's modulus;
applying to said surface first deformations which vary according to the crystallographic directions of the second support (12);
performing a molecular bonding of the first support onto said surface, the molecular bonding causing the occurrence of second deformations in said surface in the absence of the first deformations, the first deformations being opposite to the second deformations; and
removing the second support, the resulting relative deformations in said surface being smaller than 5 ppm.

2. The manufacturing method of claim 1, wherein said surface (28) is deformed by applying the second support (12) on a template (42).

3. The manufacturing method of claim 1, wherein said surface (28) is deformed by maintaining the center of the second support (12) fixed and by displacing the periphery of the second support.

4. The manufacturing method of any of claims 1 to 3, wherein the application of the first deformations comprises the stretching of said surface (28).

5. The manufacturing method of claim 4, wherein the second support (12) is made of single-crystal silicon, wherein said surface (28) is a (001) crystallographic surface, wherein the second support (12) is a cylinder having a rotational symmetry axis (D), and wherein the first deformations have a rotational symmetry of order 4 around said axis.

6. The manufacturing method of claim 5, wherein the application of the first deformations comprises applying, in a first plane containing said axis (D) and crystallographic direction [100] or [010] of the second support (12), a first spacing, measured along said axis, between the center and the periphery of said surface (28), and in a second plane containing said axis and crystallographic direction [110] of the second support, a second spacing, measured along said axis, between the center and the periphery of said surface, the first spacing being smaller than the second spacing.

7. The manufacturing method of any of claims 1 to 6, wherein the first material is isolating.

8. The manufacturing method of any of claims 1 to 7, wherein the first material is transparent.

9. The manufacturing method of any of claims 1 to 8, wherein the first material is glass.

Fig 1A

Fig 1B

Fig 1C

Fig 2

**Fig 3**

**Fig 4**

**Fig 5**

Fig 6

Fig 7

Fig 8A

Fig 8B

Fig 8C

Fig 8D

Fig 8E

**EP 2 798 672 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2848337